# EUROPÄISCHE PATENTSCHRIFT

(11) **EP 0 604 444 B1**
(45) Veröffentlichungstag und Bekanntmachung des Hinweises auf die Patenterteilung: **13.09.1995**
(21) Anmeldenummer: 92916163.6
(22) Anmeldetag: 30.07.1992
(51) Int. Cl.: G01R 19/165, G01R 31/36

(54) **SCHALTUNGSANORDNUNG ZUR ERFASSUNG EINER SPANNUNG**
CIRCUIT ARRANGEMENT TO DETECT A VOLTAGE
CIRCUIT POUR DETECTER UNE TENSION

(30) Priorität: 20.09.1991 DE 4131417
(43) Veröffentlichungstag der Anmeldung: 06.07.1994
(73) Patentinhaber: Braun Aktiengesellschaft, Frankfurt am Main (DE)
(72) Erfinder: LANG, Gerhard, D-6395 Altweilnau (DE)
(86) Internationale Anmeldenummer: DE9200642
(87) Internationale Veröffentlichungsnummer: WO9306492

(56) Entgegenhaltungen:
- DE-A- 2 517 138
- US-A- 4 829 290
- US-A- 4 906 055
- PATENT ABSTRACTS OF JAPAN vol. 8, no. 33 (P-254)(1470) 14. Februar 1984
- PATENT ABSTRACTS OF JAPAN vol. 6, no. 192 (P-145)(1070) 30. September 1982

## Beschreibung

Die Erfindung betrifft eine Schaltungsanordnung zur Erfassung einer Spannung mit einem Spannungsteiler, an dessen Teilerpunkt der Eingang eines Spannungsdetektors liegt, wobei dieser Spannungsdetektor einen Schmitt-Trigger mit Referenzspannung und einen Ausgangstreiber enthält und wobei der Ausgang des Spannungsdetektors mit dem positiven Potential der Spannung in Verbindung steht.

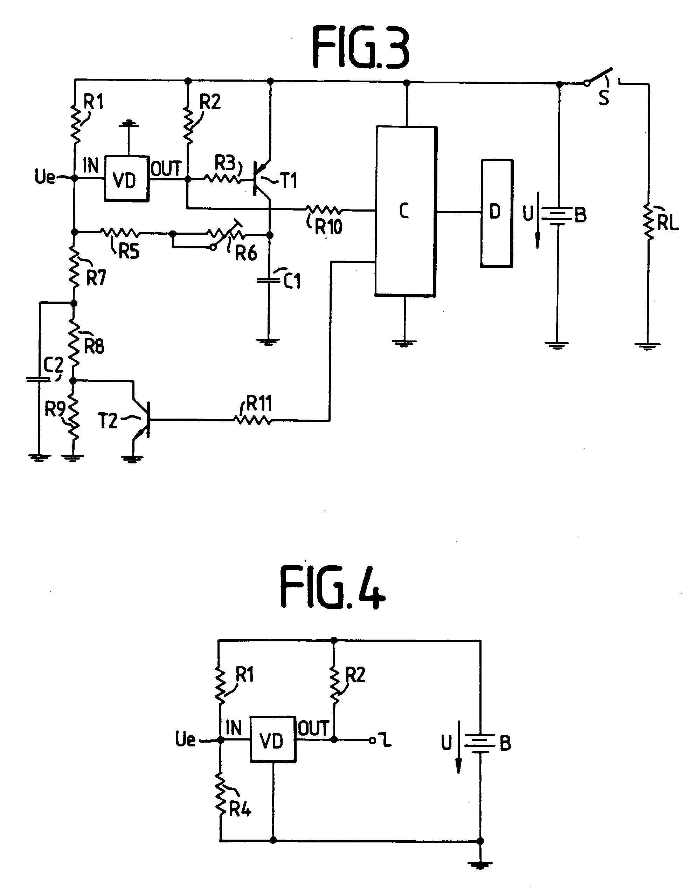

Spannungsdetektoren, die intern einen Schmitt-Trigger mit Referenzspannung und einen Ausgangstreiber enthalten, sind handelsübliche Bausteine. In Fig. 4 ist die Beschaltung eines solchen Spannungsdetektors VD dargestellt, wenn eine bestimmte Spannung, beispielsweise zweier hintereinander geschalteter Batteriezellen oder Akkumulatorzellen (B), erfaßt werden soll, die größer als die interne Referenzspannung des Spannungsdetektors VD ist. In diesem Fall ist der Batterie B ein Spannungsteiler R1/R4 parallel geschaltet und der Verbindungspunkt der beiden Widerstände R1 und R4 ist mit dem Eingang IN des Spannungsdetektors VD verbunden. Der Ausgang OUT des Spannungsdetektors VD liegt über einem Widerstand R2 am Pluspotential der Batterie B. Der Spannungsteiler R1/R4 ist so dimensioniert, daß am Eingang IN des Spannungsdetektors VD die interne Referenzspannung (beispielsweise 2,1 Volt) anliegt, wenn an der Batterie B die Spannung anliegt, die detektiert werden soll (beispielsweise 2,3 Volt). Sinkt die Batteriespannung unter diesen Wert, kippt der Ausgang des Spannungskomparators VD von "high" nach "low".

Nachteilig bei solchen handelsüblichen Spannungsdetektoren ist nur, daß diese eine Hysterese von beispielsweise 0,1 Volt aufweisen. Das bedeutet, daß bei sinkender Batteriespannung der Ausgang des Spannungsdetektors VD zwar bei Erreichen von 2,1 Volt am Eingang (entsprechend 2,3 Volt an der Batterie) der Ausgang von "high" nach "low" kippt, bei steigender Batteriespannung (beispielsweise beim Aufladen der Batterie) der Ausgang des Spannungsdetektors VD aber erst zurückkippt, wenn am Eingang 2,2 Volt (2,1 Volt + 0,1 Volt) erreicht sind. Dies ist für eine genaue Spannungserfassung in manchen Fällen unbefriedigend, beispielsweise bei der genauen Erfassung einer bestimmten Spannung an einer Batterie sowohl beim Entladen als auch beim Aufladen.

Aus der US-A-4 906 055 ist weiterhin eine Schaltungsanordnung bekannt, bei der die Spannung einer Spannungsquelle auf das Erreichen unterschiedlicher Schwellwerte überprüft wird. Dabei ist ein Spannungsdetektor vorhanden, in dem eine angelegte Spannung mit einer einzigen Referenzspannung verglichen wird. Das Erreichen mehrerer Schwellwerte der Spannung der Spannungsquelle wird dabei überprüft, indem die Spannung zum einen einem Spannungsteiler zugeführt wird und die geteilte Spannung mit dem Referenzwert verglichen wird, um das Erreichen eines ersten Schwellwertes festzustellen und indem die volle Spannung der Spannungsquelle demselben Spannungsdetektor zugeführt und damit mit demselben Referenzwert verglichen wird, um das Erreichen eines zweiten Schwellwertes der Spannung der Spannungsquelle festzustellen. Wenn dabei die geteilte Spannung die Referenzspannung unterschreitet, wird erkannt, daß die Spannung unterhalb des ersten Schwellwertes liegt. Wenn die volle Spannung der Spannungsquelle den Referenzwert unterschreitet, wird erkannt, daß die Spannung der Spannungsquelle unterhalb des zweiten Schwellwertes liegt. Um nun die richtige Spannung an den Spannungsdetektor anzulegen, d.h. entweder die geteilte Spannung oder die volle Spannung der Spannungsquelle, wird das Ausgangssignal des Spannungsdetektors einer CPU zugeführt, wobei diese CPU wiederum ein Ausgangssignal generiert, das einen steuerbaren Schalter schließt bzw. öffnet und wobei dieser steuerbare Schalter in geschlossener Stellung bewirkt, daß die volle Spannung der Spannungsquelle an den Spannungsdetektor angelegt wird. Der Prüfungsablauf findet dabei wie folgt statt: Zunächst wird die geteilte Spannung an den Spannungsdetektor angelegt. Liegt die geteilte Spannung oberhalb der Referenzspannung, gibt der Spannungsdetektor den Wert "High" aus, d.h. die CPU hält den steuerbaren Schalter nach wie vor geöffnet. Liegt die geteilte Spannung unterhalb der Referenzspannung, gibt der Spannungsdetektor den Wert "Low" aus. Das bewirkt, daß dann die CPU den steuerbaren Schalter schließt. In diesem Falle ist die Spannung der Spannungsquelle unterhalb des ersten Schwellwertes. Im nächsten Schritt wird dann wegen des geschlossenen steuerbaren Schalters geprüft, ob die volle Spannung der Spannungsquelle unterhalb des Referenzwertes liegt. Ist dies nicht der Fall, gibt der Spannungsdetektor wiederum den Wert "High" aus. Das bedeutet, daß die CPU den steuerbaren Schalter wiederum sperrt. Im nächsten Schritt wird dann wieder die geteilte Spannung dem Spannungsdetektor zugeführt und der Spannungsdetektor gibt wiederum den Wert "Low" aus. Es kommt dabei also zu einem Schwingen der Schaltung. Unterschreitet nun die volle Spannung den Referenzwert des Spannungsdetektors, so gibt dieser dann dauerhaft das Signal "Low" aus und das bedeutet, daß die Spannung der Spannungsquelle unterhalb des zweiten Schwellwertes liegt. Der Gegenstand dieser Anmeldung soll dann weiterhin Ausgangssignale der CPU erzeugen, wobei beim Unterschreiten des ersten Schwellwertes eine Leuchtdiode als Warnvorrichtung angesteuert wird. Beim Unterschreiten des zweiten Schwellwertes wird eine an der Spannungsquelle anliegende Last abgeschaltet und eine zweite Diode als Information angesteuert. Bei dieser US-Patentschrift wird hinsichtlich des Spannungssdetektors lediglich ausgeführt, daß dieser einen bestimmten Referenzwert beinhaltet. In dieser Schrift ist nicht beschrieben, daß dieser bestimmte Referenzwert eine Hysterese aufweisen kann. Hingegen offenbart diese Schrift, daß in dem Spannungsdetektor ein bestimmter Wert der Referenzspannung vorhanden sein soll, d.h., daß gerade keine Hysterese bei der Referenzspannung vorliegen soll. Wird nämlich bei dem Gegenstand dieser Anmeldung anstelle des Spannungsdetektors mit einer bestimmten Referenzspannung ein Spannungskomparator verwendet, dessen Referenzspannung eine Hysterese aufweist, so zeigt sich, daß der erste Schwellwert geprüft wird, indem die geteilte Spannung mit dem unteren Wert der Hysterese der Referenzspannung geprüft wird. Der Ausgang des Spannungskomparators steht dabei nämlich vor der Prüfung der geteilten Spannung jedesmal auf "High" wegen der vollen Spannung, die jedenfalls oberhalb des Referenzwertes liegt. Wird dabei der zweite Schwellwert geprüft, so zeigt sich, daß dabei die volle Spannung auf den oberen Wert der Hysterese der Referenzspannung geprüft wird. Wegen des Schwingens der Schaltung steht der Komparator auf "Low", weil die geteilte Spannung jedenfalls unterhalb der Referenzspannung liegt. Da aber bei dem Gegenstand der US-Patentschrift eine bestimmte Referenzspannung verwendet werden soll, kann daher ein Spannungskomparator, dessen Referenzspannung eine Hysterese aufweist, keine Verwendung finden. Im Ergebnis würden also bei einer Anwendung eines Spannungskomparators, dessen Referenzspannung eine Hysterese aufweist, bei Überprüfung des Erreichens der unterschiedlichen Schwellwerte verschiedene Referenzspannungen verwendet werden.

Aufgabe der Erfindung ist es deshalb, eine Schaltungsanordnung der eingangs genannten Art so auszugestalten, daß die hysteresefreie Erfassung einer bestimmten Spannung möglich ist.

Diese Aufgabe wird dadurch gelöst, daß das Ausgangssignal des Spannungsdetektors der Basis eines ersten Transistors zugeführt wird, daß die Kollektor-Emitter-Strecke mit einem in Reihe geschalteten Kondensator parallel zu der zu erfassenden Spannung liegt, daß der Verbindungspunkt des Kondensators mit dem ersten Transistor mit dem Eingang des Spannungsdetektors über einen ersten Widerstand verbunden ist und daß der Ausgang des Spannungsdetektors weiter dem Eingang eines Bausteins zugeführt wird, der in Abhängigkeit davon, ob sein Eingang einen konstanten Signalpegel oder eine wechselnden Signalpegel empfängt, unterschiedliche Ausgangssignale abgibt.

Sollen mit dem gleichen Spannungsdetektor mehrere festgelegte Spannungen detektiert werden oder der Wert der zu detektierenden Spannung verändert werden können, besteht der mit Bezugspotential verbundene Widerstand des ersten Spannungsteilers aus einem zweiten Spannungsteiler, dem ein Integrationskondensator parallel geschaltet ist und dessen Teilungspunkt eine Rechteckspannung zugeführt wird, deren Tastverhältnis verändert werden kann.

Weitere vorteilhafte Ausgestaltungen sind den übrigen abhängigen Ansprüchen und der Beschreibung entnehmbar.

Die Erfindung wird im folgenden anhand von in der Zeichnung dargestellten Ausführungsbeispielen näher erläutert:
- Fig. 1: zeigt eine Schaltungsanordnung zur Detektion eines bestimmten Spannungswertes an einer Batterie,
- Fig. 2 und 3: zeigen Schaltungsanordnungen zur Erfassung mehrerer Spannungswerte mit einem einzigen Spannungsdetektor.

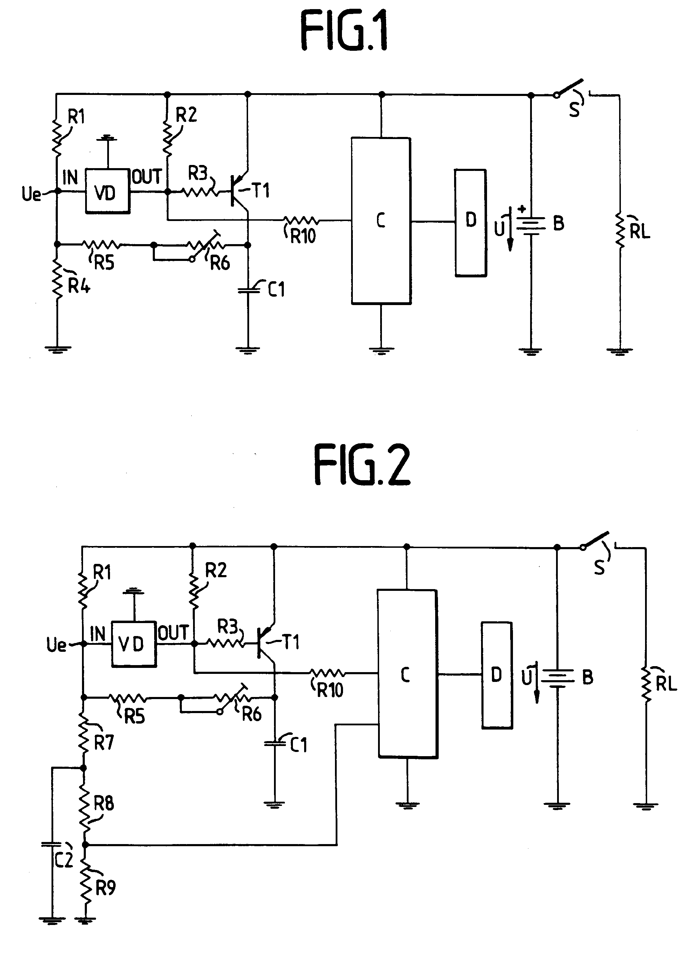

In Fig. 1 ist eine Schaltungsanordnung dargestellt, mit der angezeigt wird, wenn die Spannung U an der Batterie B einen bestimmten Spannungswert erreicht hat. An diese Batterie (Akkumulator) kann über einen Schalter S ein Lastwiderstand RL angeschlossen werden. Dieser Lastwiderstand kann der Motor eines kleinen elektrischen Geräts, beispielsweise eines Rasierers sein. Die Batterie kann über eine nicht dargestellte Ladeschaltung aufgeladen werden.

Der Batterie B ist ein aus den Widerständen R1 und R4 bestehender Spannungsteiler parallel geschaltet, womit die Spannung U der Batterie B auf die am Verbindungspunkt der Widerstände R1 und R4 anliegende Spannung Ue heruntergeteilt wird, die dem Eingang IN des Spannungsdetektors VD zugeführt wird. Der Ausgang OUT des Spannungsdetektors VD ist über den Widerstand R2 mit dem positiven Pol der Batterie B verbunden, über den Widerstand R3 mit der Basis des Transistors T1 und über den Widerstand R10 mit dem Mikroprozessor C, der die Anzeige (Display) D ansteuert.

Der Emitter des Transistors T1 liegt am Pluspol der Batterie B, der Kollektor ist über den Kondensator C1 mit Bezugspotential verbunden. Außerdem ist der Kollektor über die Widerstände R5 und R6 mit dem Verbindungspunkt der Widerstände R1/R4 des Spannungsteilers verbunden. Der Widerstand R6 ist zum Abgleich einstellbar ausgebildet.

Der Spannungsteiler R1/R4 ist so dimensioniert, daß bei Erreichen einer bestimmten Spannung U an der Batterie B die heruntergeteilte Spannung Ue am Eingang IN des Spannungsdetektors VD mit Sicherheit unter der Detektionsspannung des Spannungsdetektors VD liegt. Diese festgelegte Spannung U kann beispielsweise der "low charge" Punkt bei 2,3 Volt sein (dann ist die Batterie bis auf 10 bis 20 % ihrer Kapazität entladen). Ist die Detektionsspannung des Spannungsdetektors beispielsweise 2,1 Volt und die Toleranz ± 0,1 Volt (was nicht mit der Hysterese des Spannungsdetektors zusammenhängt), sind dies 2,0 Volt.

Die Funktionsweise der Schaltungsanordnung ist nun folgende. Ist die Batteriespannung U bis auf die zu detektierende Spannung von beispielsweise 2,3 Volt abgesunken, beträgt die Spannung Ue am Eingang IN des Spannungsdetektors VD 2,0 Volt und der Ausgang OUT des Spannungsdetektors VD wird von "high" nach "low" gekippt. "Low" ist der aktive Zustand des Spannungsdetektors VD. Der Transistor T1 wird nun durchgeschaltet und somit die Reihenschaltung der Widerstände R5, R6 dem Widerstand R1 parallel geschaltet. Die Eingangsspannung Ue (Teilerspannung) wird dadurch in dem Maße heraufgesetzt, daß sie größer ist als die Detektionsspannung des Spannungsdetektors plus der Hysteresespannung, wodurch der Spannungsdetektor nun wieder zurückkippt (Rückkippspannung) und der Ausgang OUT wieder auf "high" liegt. Der Transistor 1 wird wieder gesperrt und somit die Parallelschaltung der Widerstände R5, R6 zum Widerstand R1 aufgehoben, wodurch die Teilerspannung Ue nun wieder unterhalb der Detektionsspannung des Spannungsdetektors VD liegt und der Ausgang OUT erneut nach "low" kippt.

Die Schaltung oszilliert. Der Kondensator C1 verzögert die Kippvorgänge und verringert so die Schwingfrequenz auf beispielsweise ca. 1 kHz. Am Ausgang OUT steht eine Rechteckspannung mit einer Amplitude in der Größenordnung der Batteriespannung U an.

Die Oszillation ist erst dann nicht mehr möglich, wenn die Rückkippspannung des Spannungsdetektors bei durchgeschaltetem Transistor T1 nicht mehr erreicht wird. In diesem Moment bleibt der Spannungsdetektor VD gekippt und dessen Ausgangsspannung konstant auf "low". Dieser Spannungspunkt wird mit dem Widerstand R6 abgeglichen.

Es kann somit allein durch das Anliegen eines konstanten Signalpegels am Ausgang des Spannungsdetektors VD gegenüber einem wechselnden (oszillierenden) Signalpegel ein festgelegter Wert der Versorgungsspannung erkannt werden. Der festgelegte Spannungswert wird hysteresefrei detektiert, das heißt, es spielt keine Rolle ob der festgelegte Spannungswert von höheren oder von niedrigeren Spannungswerten her erreicht wird, da zum Abgleich nicht die interne Referenzspannung des Spannungsdetektors (2,1 Volt) benutzt wird, sondern dessen Rückkippspannung ("Releasespannung").

Die Schaltungsanordnungen in Figur 2 und 3 sind eine Erweiterung der Figur 1 zur Erfassung mehrerer Spannungen mit lediglich einem Spannungsdetektor VD. Der Widerstand R4 aus Figur 1 ist hier in die in Serie geschalteten Widerstände R7, R8 und R9 aufgeteilt, wobei R7 mit dem Eingang des Spannungsdetektors VD und R9 mit Bezugspotenial verbunden ist. Parallel zu der Reihenschaltung der Widerstände R8 und R9 liegt der Integrationskondensator C2.

In Figur 2 ist ein Ausgang des Mikroprozessors C an den Verbindungspunkt der Widerstände R8 und R9 angeschlossen. Der Mikroprozessor führt diesem Verbindungspunkt ein Rechtecksteuersignal zu, das in seinem Tastverhältnis variierbar ist.

Durch dieses veränderbare Tastverhältnis läßt sich in Verbindung mit den Widerständen R7, R8, R9 und dem Integrationskondensator C2 der Rückkippspannungspunkt des Spannungsdetektors VD über einen großen Bereich der Spannung U der Batterie B verschieben. Je größer das Tastverhältnis der zugeführten Rechteckspannung ist, d. h. je größer das Puls/Pausen-Verhältnis ist, um so höher ist der Mittelwert der zugeführten Spannung. Dementsprechend wird die Spannung am Verbindungspunkt des Kondensators C2 mit dem Widerstand R8 und somit auch die Spannung Ue am Eingang des Spannungsdetektors VD angehoben, wodurch die Rückkippspannung des Spannungsdetektors bei höheren Batteriespannungen U erreicht wird.

Es können somit, wie an Hand von Figur 1 beschrieben, durch Verändern des Tastverhältnisses der zugeführten Rechteckspannung beliebig viele Spannungspunkte der Batteriespannung U festgelegt und erkannt werden. Durch Erkennen eines Spannungspunktes und anschließend erneuter Festlegung eines nächsten Spannungspunktes durch entsprechende Veränderung des Tastverhältnisses der zugeführten Rechteckspannung, kann die Kennlinie der Spannung einer Batterie beim Laden und/oder Entladen in Abhängigkeit von der Zeit nachvollzogen werden.

Durch Zuordnen bestimmter Spannungspunkte einer Entlade- oder Ladekennlinie der Batterie (z.B. zwischen 2,5 Volt und 2,2 Volt im Abstand von 50 mV) zu einem optischen Signal der Anzeige (des Displays) D, wird der aktuelle Ladezustand der Batterie angezeigt. Besteht das Display D aus mehreren Segmenten, werden diese vom Mikroprozessor C so gesteuert, daß bei vollem Ladezustand (größte detektierte Spannung) alle Segmente angesteuert werden und bei praktisch leerer Batterie (kleinste detektierte Spannung) kein Segment angesteuert wird.

Erfolgt eine laufende Ladezustandsanzeige des Displays D mit mehreren Segmenten auf Zeitbasis, d.h. in Abhängigkeit davon, wie lange der Lastwiderstand R_{L} (Verbraucher) an die Batterie angeschaltet war oder wie lange die Batterie geladen wurde, wird durch den Vergleich der detektierten Spannungspunkte im Betrieb mit den im Mikroprozessor gespeicherten Werten der Lade- bzw. Entladekennlinie der Batterie die Anzeige bei Abweichungen entsprechend korrigiert.

Figur 3 zeigt eine Anordnung für den Fall, daß der Spannungsteiler nicht genügend hochohmig ist, d.h. der die Rechteckspannung liefernde Ausgang des Mikroprozessors C die benötigte Leistung nicht erbringen kann. In diesem Fall wird das Rechtecksignal des Mikroprozessors C über den Widerstand R11 der Basis eines Transistors T2 zugeführt, dessen Kollektor-Emitter-Strecke parallel zum Widerstand R9 liegt. Der Transistor T2 wird entsprechend dem Tastverhältnis des zugeführten Rechtecksignals leitend oder gesperrt. Ansonsten ist die Funktionsweise der Schaltungsanordnung die gleiche wie die von Figur 2.

Alle beschriebenen Schaltungsanordnungen arbeiten selbstschwingend und bedürfen keiner externen Steuerspannungen. In Folge des geringen Strombedarfs können die Schaltungen an der Versorgungsspannung U auch bei ausgeschaltetem Gerät (Lastwiderstand R_{L} von Batterie getrennt) angeschaltet bleiben, ohne daß sich die Batterie in unzumutbarer Weise entlädt.

## Patentansprüche

1. Schaltungsanordnung zur Erfassung einer Spannung (U) mit einem ersten Spannungsteiler (R1, R4), an dessen Teilungspunkt der Eingang eines Spannungsdetektors (VD) liegt, wobei dieser Spannungsdetektor (VD) einen Schmitt-Trigger mit Referenzspannung und einen Ausgangtreiber enthält und wobei der Ausgang des Spannungsdetektors (VD) mit dem positiven Potential der Spannung (U) in Verbindung steht,
**dadurch gekennzeichnet,**
daß das Ausgangssignal des Spannungsdetektors (VD) der Basis eines ersten Transistors (T1) zugeführt wird, daß die Kollektor-Emitter-Strecke des ersten Transistors (T1) mit einem in Reihe geschalteten Kondensator (C1) parallel zu der zu erfassenden Spannung (U) liegt, daß der Verbindungspunkt des Kondensators (C1) mit dem ersten Transistor (T1) mit dem Eingang des Spannungsdetektors (VD) über einen ersten Widerstand (R5, R6) verbunden ist und daß der Ausgang des Spannungsdetektors (VD) weiter dem Eingang eines ersten Bausteins zugeführt wird, der in Abhängigkeit davon, ob sein Eingang einen konstanten Signalpegel oder eine wechselnden Signalpegel empfängt, unterschiedliche Ausgangssignale abgibt.

2. Schaltungsanordnung nach Anspruch 1,
**dadurch gekennzeichnet,**
daß der erste Baustein in Abhängigkeit von seinem Eingangssignal eine Anzeige (D) derart steuert, daß erkennbar ist, ob die erfaßte Spannung (U) einen bestimmten Spannungswert erreicht hat oder/und oberhalb oder unterhalb des bestimmten Spannungswertes liegt.

3. Schaltungsanordnung nach Anspruch 1,
**dadurch gekennzeichnet**,
daß ein Teil des ersten Widerstandes (R5, R6) einstellbar (R6) ausgebildet ist.

4. Schaltungsanordnung nach Anspruch 1,
**dadurch gekennzeichnet**,
daß der mit Bezugspotential verbundene Widerstand (R4) des ersten Spannungsteilers (R1, R4) aus einem zweiten Spannungsteiler (R8, R9) besteht, dem ein Integrationskondensator (C2) parallel geschaltet ist, und daß ein zweiter Baustein dem Teilungspunkt des zweiten Spannungsteilers (R8, R9) eine Rechteckspannung zuführt.

5. Schaltungsanordnung nach Anspruch 4,
**dadurch gekennzeichnet**,
daß zwischen dem zweiten Spannungsteiler (R8, R9) und dem Eingang (IN) des Spannungsdetektors (VD) ein zweiter Widerstand (R7) liegt.

6. Schaltungsanordnung nach Anspruch 4,
**dadurch gekennzeichnet,**
daß das Tastverhältnis der Rechteckspannung veränderbar ist.

7. Schaltungsanordnung nach Anspruch 1 oder 4,
**dadurch gekennzeichnet,**
daß der erste Baustein und/oder der zweite Baustein Bestandteile eines Mikroprozessors (C) sind.

8. Schaltungsanordnung nach Anspruch 6,
**dadurch gekennzeichnet**,
daß mittels unterschiedlicher Tastverhältnisse der Rechteckspannung verschiedene bestimmte Spannungswerte der Spannung (U) festgelegt sind und daß das Erreichen dieser bestimmten Spannungswerte auf einem Display (D) angezeigt wird.

9. Schaltungsanordnung nach Anspruch 6,
**dadurch gekennzeichnet**,
daß die zu erfassende Spannung (U) die Versorgungsspannung einer Batterie (B) ist, daß mittels unterschiedlicher Tastverhältnisse der Rechteckspannung verschiedene bestimmte Spannungswerte der Batteriespannung festgelegt sind, daß die Versorgungsspannung der Batterie B mit der bekannten Lade-/Entladekennlinie der Batterie verglichen wird und bei auftretenden Abweichungen eine zeitgesteuerte Ladezustandsanzeige entsprechend korrigiert wird.

## Claims

1. A circuit arrangement to detect a voltage (U), including a first voltage divider (R1, R4) having applied to its divider node the input of a voltage detector (VD) which comprises a Schmitt-Trigger with reference voltage and an output driver, with the output of the voltage detector (VD) being connected to the positive potential of the voltage (U),
**characterized in that** the output signal of the voltage detector (VD) is applied to the base of a first transistor (T1), that the collector-emitter circuit of the first transistor (T1), together with a series-connected capacitor (C1), is connected in parallel with the voltage (U) to be detected, that the junction of the capacitor (C1) and the first transistor (T1) is connected to the input of the voltage detector (VD) through a first resistor (R5, R6), and that the output of the voltage detector (VD) is further applied to the input of a first component delivering different output signals in dependence upon whether its input receives a constant signal level or a varying signal level.

2. A circuit arrangement as claimed in claim 1,
**characterized in that** the first component controls a display device (D) in dependence upon its input signal, such as to enable it to recognize whether the detected voltage (U) has reached a specified voltage value and/or lies above or below the specified voltage value.

3. A circuit arrangement as claimed in claim 1,
**characterized in that** part of the first resistor (R5, R6) is adjustable (R6).

4. A circuit arrangement as claimed in claim 1,
**characterized in that** the resistor (R4) of the first voltage divider (R1, R4) connected to reference potential is comprised of a second voltage divider (R8, R9) to which an integrating capacitor (C2) is connected in parallel, and that a second component delivers to the divider node of the second voltage divider (R8, R9) a square-wave voltage.

5. A circuit arrangement as claimed in claim 4,
**characterized in that** a second resistor (R7) is inserted between the second voltage divider (R8, R9) and the input (IN) of the voltage detector (VD).

6. A circuit arrangement as claimed in claim 4,
**characterized in that** the pulse duty factor of the square-wave voltage is variable.

7. A circuit arrangement as claimed in claim 1 or claim 4,
**characterized in that** the first component and/or the second component are parts of a microprocessor (C).

8. A circuit arrangement as claimed in claim 6,
**characterized in that** different specified values of the voltage (U) are determined by means of varying pulse duty factors of the square-wave voltage, and that a display device (D) provides a suitable indication when these specified voltage values are reached.

9. A circuit arrangement as claimed in claim 6,
**characterized in that** the voltage (U) to be detected is the supply voltage of a battery (B), that different specified values of the battery voltage are determined by means of varying pulse duty factors of the square-wave voltage, that the supply voltage of the battery B is compared with the known charging/discharging characteristic of the battery, and that a time-controlled charge-status indication is corrected correspondingly when a deviation is established.

## Revendications

1. Circuit de détection d'une tension (U) équipé d'un premier diviseur de tension (R1, R4), au point de division duquel se trouve l'entrée d'un détecteur de tension (VD), ce détecteur de tension (VD) comportant un trigger de Schmitt avec tension de référence et un étage de sortie et la sortie du détecteur de tension (VD) étant reliée au potentiel positif de la tension (U),
caractérisé en ce que
le signal de sortie du détecteur de tension (VD) est appliqué à la base d'un premier transistor (T1), en ce que le trajet collecteur-émetteur du premier transistor (T1) se trouve, avec un condensateur monté en série (C1), en parallèle avec la tension (U) à détecter, en ce que le point de liaison du condensateur (C1) et du premier transistor (T1) est relié à l'entrée du détecteur de tension (VD) par l'intermédiaire d'une première résistance (R5, R6 ) et en ce que la sortie du détecteur de tension (VD) est appliquée en outre à l'entrée d'un premier composant, qui en fonction du fait que son entrée reçoit un niveau de signal constant ou un niveau de signal alternatif, délivre différents signaux de sortie.

2. Circuit selon la revendication 1, caractérisé en ce que le premier composant commande, en fonction de son signal d'entrée, un affichage (D), de telle sorte qu'on peut reconnaître si la tension détectée (U) a atteint une valeur de tension déterminée ou/et se trouve au-dessus ou au-dessous de la valeur de tension déterminée.

3. Circuit selon la revendication 1, caractérisé en ce qu'une partie de la première résistance (R5, R6) est réalisée de façon réglable (R6).

4. Circuit selon la revendication 1, caractérisé en ce que la résistance (R4) reliée au potentiel de référence du premier diviseur de tension (R1, R4), se compose d'un second diviseur de tension (R8, R9), sur lequel est disposé en parallèle un condensateur d'intégration (C2), et en ce qu'un second composant applique, au point de division du second diviseur de tension (R8, R9), une tension rectangulaire.

5. Circuit selon la revendication 4, caractérisé en ce qu'entre le second diviseur de tension (R8, R9) et l'entrée (IN) du détecteur de tension (VD) se trouve une seconde résistance (R7).

6. Circuit selon la revendication 4, caractérisé en ce que le rapport cyclique de la tension rectangulaire est variable.

7. Circuit selon la revendication 1 ou 4, caractérisé en ce que le premier composant et/ou le second composant sont des éléments d'un microprocesseur (C).

8. Circuit selon revendication 6, caractérisé en ce qu'au moyen de différents rapports cycliques de la tension rectangulaire, différentes valeurs de tension déterminées de la tension (U) sont fixées et en ce que l'obtention de ces valeurs de tension déterminées est indiquée sur un affichage (D).

9. Circuit selon la revendication 6, caractérisé en ce que la tension à détecter (U) est la tension d'alimentation d'une batterie (B), en ce qu'au moyen de rapports cycliques différents de la tension rectangulaire, différentes valeurs de tension déterminées de la tension de batterie sont fixées, en ce que la tension d'alimentation de la batterie B est comparée à la caractéristique de charge/décharge connue de la batterie et dans le cas de l'apparition d'écarts, une indication de l'état de charge commandée temporairement est corrigée de façon correspondante.
